# EUROPEAN PATENT APPLICATION

(11) **EP 3 000 612 A1**
(43) Date of publication of application: **30.03.2016**
(21) Application number: 14800392.4
(22) Date of filing: 20.05.2014
(51) Int. Cl.: B41N 1/24, B41C 1/14, G03F 7/12, H05K 3/12

(54) **STRUCTURE AND STENCIL PRINTING PLATE WHICH HAVE BEEN SUBJECTED TO WETTABILITY-IMPROVING SURFACE MODIFICATION, AND PROCESSES FOR PRODUCING BOTH**

(30) Priority: 20.05.2013 JP 2013106025
(71) Applicant: Taiyo Yuden Chemical Technology Co., Ltd., Takashi-shi, Gunma 3701201 (JP)
(72) Inventor: SHIBUSAWA Kunihiko, Takasaki-shi Gunma 370-1201 (JP)
(74) Representative: Boult Wade Tennant
(86) International application number: PCT/JP2014/063282
(87) International publication number: WO 2014/189026

(57) **Abstract**

In one embodiment of a structure, the wettability of the squeegeed surface of the structure for screen printing is increased and a water/oil repellent layer is tightly formed The structure may include: a screen mesh as a substrate having a plurality of through-holes (apertures); an emulsion layer formed on the screen mesh and having printing pattern openings; and a water repellent layer having water repellence and formed on the printing substrate surface of the screen mesh on which the emulsion layer is formed The squeegeed surface of the screen mesh on which the emulsion layer is formed is subjected to a surface modification treatment for better wettability.

## Description

### TECHNICAL FIELD

### CROSS-REFERENCE TO RELATED APPLICATIONS

This application is based on and claims the benefit of priority from Japanese Patent Application Serial No. 2013-106025 (filed on May 20, 2013), the contents of which are hereby incorporated by reference in their entirety.

The present invention relates to a structure and a printing stencil and a method of manufacturing the same, and in particular to a structure and a printing stencil subjected to surface modification treatment for better wettability and a method of manufacturing the same.

### BACKGROUND

There have conventionally been proposed screen stencils for screen printing having modified wettability with an ink (a paste) by applying a water repellent agent such as silane coupling agent to a surface layer of a printing stencil (see, e.g., Japanese Patent No. Hei 5-80522). These screen stencils are provided with ink repellence by overlaying an emulsion placed on a screen with an active agent such as a fluorine-based resin which reduces the surface tension of the emulsion, thereby eliminating bleeding in printing irrespective of an increased number of strokes of a squeegee.

### SUMMARY

However, many of water repellent agents such as silane coupling agent are liquids having a small surface tension; therefore, when a water repellent agent is applied onto a printing substrate surface side for suppressing bleeding of the ink in printing, the water repellent agent may be unintentionally adhered to a sectional surface of the opening forming a printing pattern and to a substrate (a screen mesh) and a rib exposed at the opening, and additionally, the water repellent agent may unintentionally turn onto a squeegeed surface side through the opening. As a result, the water repellence is unintentionally provided to some portions and thus reduces the printing quality; for example, the ink is not filled fully in the opening, which causes blur printing, or the ink forms "lumps" on the squeegeed surface side, which makes it difficult for the ink to be placed evenly.

It is possible but troublesome to wipe off the water repellent agent applied unintentionally onto such portions. In particular, when a primer layer is formed to fix the water repellent agent tightly on a substrate, the liquid primer layer is also unintentionally formed on such portions; therefore, it is difficult to remove the tightly fixed water repellent agent such as silane coupling agent. Additionally, many printing stencils include heated stainless steel; such examples are a mesh in an emulsion stencil and printing pattern openings in a metal mask. Such heated stainless steel has reduced number of functional groups (hydroxyl groups) in the surface layer thereof, making it difficult to form a water/oil repellent layer tightly on the printing substrate surface side, for example.

One object of the embodiments of the present invention is to improve wettability of a squeegeed surface of a structure used for screen printing. Another object of the embodiments of the present invention is to form a water/oil repellent layer tightly in a structure used for screen printing. Other objects of the embodiments of the present disclosure will be apparent with reference to the entire description in this specification.

Members included in printing stencils and stencils such as screen meshes should be designed to have wettability in accordance with the type of an ink used for printing such as those water-based or oil-based, various viscosities and thixotropy of an aggregate ink including a diluent such as water or solvent added in the ink, pigment and metal powder, and affinity of the ink at an interface with a printing sheet for transcription and a squeegee for rolling the ink for filling. The wettability should be designed for each of "a printing substrate surface" (printing sheet surface) which is one of the surfaces of a stencil and contacts the printing substrate side, "a squeegeed surface" which is opposite to the "printing substrate surface" and undergoes squeegeeing, and "a sectional surface" in the portion constituting the thickness of a printing pattern opening (the surface of fiber threads positioned in the apertures and constituting the thickness of a screen mesh). In some cases, these surfaces should preferably have different wettabilities.

For example, in the printing stencils and the members included in stencils such as screen meshes, typically, a squeegeed surface thereof may be required to have affinity with an ink so as to appropriately roll the ink by squeegeeing to achieve sufficient thixotropy (a frictional resistance for rolling the ink), and wettability for arranging the ink uniformly without repellence and filling the ink uniformly into the printing pattern openings in the stencil (such that the surface ensures affinity with the ink and spreads the ink). Additionally, the printing substrate surface may be required to have demoldability with an ink for correctly transferring the ink through the printing pattern openings onto the printing substrate, and repellence of the ink to prevent blurring of the ink. To meet such requirements, the printing substrate surface may be intentionally subjected to a surface treatment for water repellence or water and oil repellence. Further, the "sectional surface" of the printing pattern opening may be required to have demoldability for high viscosity inks and affinity (ability of facilitating filling of the ink) for low viscosity inks.

Meshes such as #500, #640, #730, and #840 meshes (high meshes) having very fine fiber threads finely woven together have begun to be used as screen meshes included in a stencil for printing electronic components, in order to meet printing requirements for fineness and precision, and smaller thicknesses of prints. The contact angle with water of a high mesh #500-19-28 formed of a stainless steel thread and not subjected to a surface treatment for water repellence and water and oil repellence is about 106°, indicating vary high water repellence. The contact angle with water of a planar plate of normal untreated stainless steel (surface 2B) is about 70 to 80°; and a mesh made of stainless steel has a three-dimensional structure (a structure with fractal dimensions closer to three) having threads woven together, where openings (apertures between threads) extend from one surface to the other. Therefore, it can be presumed that such a mesh has a higher "structural water repellence" than a surface of a planar plate not having openings extending therethrough.

The hole diameter of the openings is as small as about 20 µm in metal printing stencils having a large number of printing pattern openings having a fine diameter made by applying a laser beam on a thin stainless steel plate, and metal printing stencils (metal masks) having a large number of printing pattern openings having a fine diameter made of an electroformed foil formed by forming a plating film on a mold for plating films formed by photolithography and then removing the plating film from the mold It is already usual that one stencil has more than one million printing pattern openings. Thus, some of printing stencils including a fine screen mesh having fine fiber threads and metal stencils having a large number of printing pattern openings having a fine diameter have water repellent surface wettability unintentionally (structural water repellence).

For example, when a water-based ink is used for printing with a printing stencil or a printing screen mesh having a squeegeed surface exhibiting the structural water repellence mentioned above and a surface having a contact angle with water of more than 90°, reverse capillary pressure occurs in the printing pattern openings of the printing stencil and apertures of the screen mesh, making it difficult for the ink to enter and fill the openings and the apertures. Further, as a result, voids (air) may remain under the ink in the openings and the apertures. The remaining voids are transferred to the printing medium (the destination of transfer of the ink) along with the ink during squeegeeing, causing shortage or unevenness of transferred ink which may lead to blur printing or other deficiencies. Further, in the case where an oil-based ink (an ink including a binder or a diluent having a surface tension close to that of an oil) or a solvent is used for printing with a printing stencil or a printing screen mesh including an oil repellent surface having a contact angle with oil of more than 90°, the same problem as in the case for the water-based ink mentioned above may occur. Still further, even if the contact angle with oil is less than 90°, when a printing stencil or a printing screen mesh having a water repellent surface or an oil repellent surface and thus having a low wettability with water or oil is used, the deficiency such as blur printing caused by inclusion of voids occurring during squeegeeing is more significant when squeegeeing speed is increased, or printing takt time is reduced for increasing productivity.

When a water-based ink cleanser is used, after printing, for cleansing a printing stencil or a printing screen mesh having a squeegeed surface exhibiting the structural water repellence and a surface having a contact angle with water of more than 90°, reverse capillary pressure occurs in the printing pattern openings and apertures, making it difficult for the ink cleanser to enter and fill the printing pattern openings and the apertures. Therefore, the ink remaining in the printing pattern openings and apertures cannot be cleaned well; and the ink that remains and solidifies may cause degradation of the printing stencil in printing quality and durability. The same problem occurs in the case where an oil-based ink is used for printing with a printing stencil or a printing screen mesh including an oil-repellent surface having a contact angle with oil of more than 90°. For example, the same problem as in cleansing the ink occurs when it is difficult for an organic solvent and alcohol for cleansing having about the same surface tension as oil to enter and fill the printing pattern openings of the stencil.

Such a problem may occur when the printing stencil unintentionally exhibits structural water repellence, as well as in the case where, e.g., when a surface treatment for water repellence or water and oil repellence is intentionally applied to a printing substrate surface of the printing stencil or a screen mesh, a material used for the surface treatment (particularly a liquid material having a very low surface tension) adheres to the printing pattern openings (sectional surface) or apertures (sectional surface) and spreads therethrough onto the squeegeed surface, resulting in unintentional surface treatment for water repellence or water and oil repellence on the squeegeed surface.

A structure according to one embodiment of the present invention is a structure for screen printing having a plurality of through-holes, wherein at least a part of the structure is subjected to surface modification treatment for better wettability.

A printing stencil according to one embodiment of the present invention is a printing stencil comprising the above structure, wherein the structure is composed of a screen mesh having a plurality of through-holes and an emulsion layer formed on the screen mesh and having printing pattern openings, and at least a part of the screen mesh on which the emulsion layer is formed is subjected to surface modification treatment for better wettability.

A method of manufacturing a structure according to one embodiment of the present invention is a method of manufacturing a structure for screen printing, comprising the steps of: (a) preparing a substrate having a plurality of through-holes; and (b) providing surface modification treatment for better wettability on at least a part of the substrate.

A method of manufacturing a printing stencil according to one embodiment of the present invention is a method of manufacturing a printing stencil for screen printing, comprising the steps of: (a) preparing a screen mesh having a plurality of through-holes; (b) forming an emulsion layer having a plurality of printing pattern openings on the screen mesh; and (c) providing surface modification treatment for better wettability to at least a part of the screen mesh on which the emulsion layer is formed

According to various embodiments of the present invention, the wettability of a squeegeed surface of a structure used for screen printing can be increased, and a water/oil repellent layer can be formed tightly in a structure used for screen printing.

### BRIEF DESCRIPTION OF THE DRAWINGS

Fig. 1 is a schematic view schematically illustrating a section of a structure 10 according to an embodiment of the present invention.
Fig. 2 is an electron microscope photograph of a printing substrate surface of Example 1 (400 magnifications).
Fig. 3 is an electron microscope photograph of a printing substrate surface of Example 2 (400 magnifications).
Fig. 4 is an electron microscope photograph of a printing substrate surface of Comparative Example 1 (400 magnifications).
Fig. 5 is an electron microscope photograph of a printing substrate surface of Example 2 (1000 magnifications).
Fig. 6 is an electron microscope photograph of a squeegeed surface of Example 2 (1,000 magnifications).
Fig. 7 is an electron microscope photograph of a squeegeed surface of Comparative Example 1 (1,000 magnifications).
Fig. 8 is a photograph of a print printed with a screen stencil of Comparative Example 5.
Fig. 9 is a photograph of a print printed with a screen stencil of Example 7.

### DESCRIPTION OF EXAMPLE EMBODIMENTS

Various embodiments of the present disclosure will now be described with reference to the attached drawings. In the drawings, the same or similar components are denoted by the same or similar reference signs, and the detailed description of the same or similar components is appropriately omitted

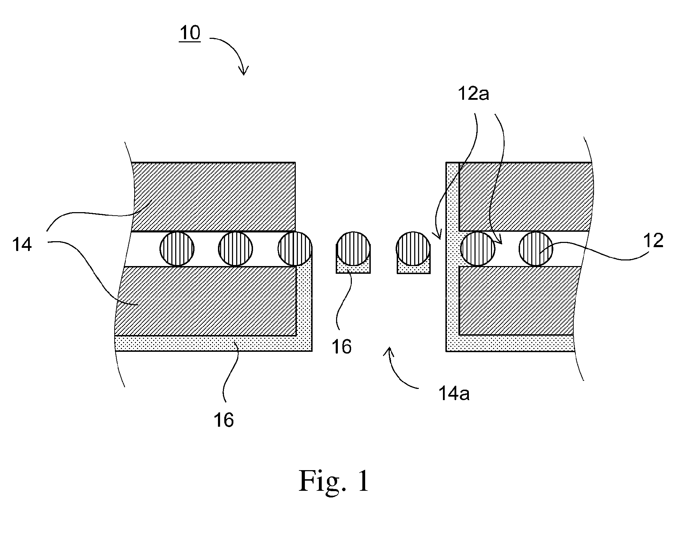

Fig. 1 is a schematic view schematically illustrating a section of a structure 10 according to an embodiment of the present invention. As shown, the structure 10 according to an embodiment may include: a screen mesh 12 as a substrate having a plurality of through-holes (apertures) 12a; an emulsion layer 14 formed on the screen mesh 12 and having printing pattern openings 14a; and a water repellent layer 16 having water repellence and formed on the printing substrate surface of the screen mesh 12 on which the emulsion layer 14 is formed The squeegeed surface of the screen mesh 12 on which the emulsion layer 14 is formed is subjected to a surface modification treatment for better wettability. The structure 10 may be used as a printing stencil as follows. The screen mesh 12 may be strung on a frame not shown. An ink (paste) may be applied from above in the drawing and squeegeed Thus, a printing pattern formed of the printing pattern openings 14a may be printed on a printing medium not shown positioned below in the drawing. Fig. 1 schematically illustrates the structure 10 according to an embodiment of the present disclosure, and it should be noted that dimensional relationship is not accurately reflected in the drawing.

The screen mesh 12 according to an embodiment may be fabricated by weaving threads of various materials and diameters. The surface roughness, sectional shape, and weaving method of the threads constituting the screen mesh 12 may be appropriately varied in accordance with the applications. The sectional shapes may include, for example, circular, oval, rectangular, polygonal, irregular, and star shapes. Examples of weaving method may include plain weave, twill weave, and three-dimensional weave. The material of the threads constituting the screen mesh 12 may be, for example, a metal such as stainless steel, steel, copper, or tungsten or an alloy thereof. The metal may also be an amorphous metal, etc. Further, the material of the threads constituting the screen mesh 12 may also be a chemical fiber such as polypropylene, polyester, polyethylene, nylon, or vinyl, a mixed fiber such as rayon, a carbon fiber, an inorganic material such as glass fiber, or a natural fiber such as wool, silk, cotton, or cellulose. Further, the threads constituting the screen mesh 12 may be those pressed (calendered products) so as to reduce the thickness of "intersections" at which fiber threads cross each other, those having surface roughness of the surface layer of the fiber threads modified by a physical process such as sandblasting or a chemical process such as chemical etching, those subjected to surface treatment such as wet plating or dry plating, or those having a chemical conversion treatment film or a paint applied thereon for preventing diffuse reflection of ultraviolet rays during later exposure of the printing pattern after application of the emulsion. For example, the screen mesh 12 may be a mesh #500-19. In a mesh #500-19, the wire rods (fiber threads) constituting the mesh may have a diameter of 19 µm, the mesh openings (through-holes 12a) may have a width (apertures, i.e., the intervals between the neighboring wire rods) of about 30 µm, and the mesh count may be 500. The mesh count of 500 may indicate that 500 mesh wire rods are present in a width of one inch. The specifications of the screen mesh 12 are not limited to those described herein such as the substance, wire diameter, mesh count, uniformity of the size of mesh openings, positions of mesh openings, taper angle of mesh openings, and shape of the mesh openings; these specifications may be varied in accordance with printing method, printing pattern, printing medium, and required endurance. In an embodiment, the screen mesh 12 may be ordinarily fabricated by weaving thread-like material but may also be fabricated by other methods. For example, the screen mesh 12 may be fabricated by electrotyping, printing, and photolithography. Also, the screen mesh 12 may be fabricated by forming through-holes in a substrate by various methods such as laser processing, etching, drilling, punching, and electric discharging. The through holes formed in these processes may correspond to the through-holes 12a of the screen mesh 12. The above materials and fabrication methods may be appropriately combined Further, the edges of the mesh openings of the screen mesh 12 may be appropriately chamfered The screen mesh 12 may be a combination of a plurality of meshes. For example, meshes of the same type or different types may be combined together.

Further, the emulsion layer 14 in an embodiment may not necessarily be used with a mesh. The emulsion layer 14 may be formed on various resins, metals, glasses, ceramics, or composite material thereof, and desired printing pattern openings may be formed in the emulsion layer 14 by a laser process, etching, drilling, punching, or other appropriate methods. The emulsion layer 14 may also include the printing pattern openings formed with "a mold" by electroforming and have a plate-like or film-like shape. Thus, the pattern openings in the stencil do not necessarily include a mesh.

In an embodiment, the emulsion layer 14 can be formed of, e.g., a diazo-based photosensitive emulsion. The printing pattern openings 14a may be formed in the emulsion layer 14 by, for example, photolithography so as to correspond to a printing pattern. The printing pattern openings 14a may be formed so as to extend through the emulsion layer 14 in the depthwise direction. In the printing pattern openings 14a, the screen mesh 12 is exposed In a photolithographic process, the emulsion layer 14 formed on the screen mesh 12 may be exposed to light in a photomask pattern to cure a part of the emulsion layer 14, and then the other region of the emulsion layer 14 than the part cured by the exposure to light may be removed to leave only the cured part on the screen mesh 12, so that the printing pattern opening 14a is formed The substance and forming method of the emulsion layer 14 can be appropriately selected within the purport of the present invention. For example, the emulsion layer 14 may be formed of a resin-based emulsion such as a water-soluble film, a lacquer film, a varnish stencil paper, a nylon resin stencil paper; and then the printing pattern may be formed in the emulsion layer 14 by partial application of an excimer laser beam. Also, the emulsion layer 14 may be formed of a metal foil having a printing pattern previously formed by applying a laser beam or a metal foil having a printing pattern previously formed by electroforming; and these metal foils having printing patterns previously formed thereon can be affixed on the screen mesh 12. Furthermore, in place of directly attaching the screen mesh 12 having a printing pattern to the frame, a support screen separate from the screen mesh 12 may be attached to the frame, and then the screen mesh 12 may be attached to the support screen.

In an embodiment, the water repellent layer 16 may be formed of a thin film including a fluorine-containing silane coupling agent. Such a fluorine-containing silane coupling agent may be "FG-5010Z130-0.2" manufactured by Fluoro Technology Corporation. In an embodiment, the water repellent layer 16 may be formed so as to have a small thickness which has substantially no influence on the volume of printing paste which passes through the printing pattern opening 14a; for example, the thickness may be approximately 20 nm. Further, in an embodiment, the water repellent layer 16 may be formed via a primer layer for fixing the water repellent layer more tightly on the substrate. The thickness of the water repellent layer 16 is not limited thereto and can be appropriately changed depending on types of water repellent agent to be used; for instance, the thickness may range from 1 nm to 1 µm.

Various methods can be used to form the water repellent layer 16 on the emulsion layer 14 and the screen mesh 12 exposed in the printing pattern openings 14a of the emulsion layer 14. For example, the water repellent layer 16 may be applied by using fabrics such as unwoven fabrics, a sponge, a sponge-like roller, a brush, and/or other various application tools. Also, the water repellent layer 16 may be formed by spraying the fluorine-containing silane coupling agent. The water repellent layer 16 may be formed by other various methods including dipping, resistance heating, evaporation, and/or other various methods. The water repellent layer 16 may have two-layer structure including a first layer composed mainly of a coupling agent and a second layer composed mainly of a water repellent material or a water and oil repellent material The printing substrate surface of the structure 10 may include fluorine atoms when the water repellent layer 16 is formed of the fluorine-containing silane coupling agent.

As shown in Fig. 1, the water repellent layer 16 may be formed on the printing substrate surface side (the lower side in the drawing); due to a small surface tension, the water repellent agent such as the silane coupling agent may be unintentionally adhered to the sectional surface in the printing pattern openings 14a and the screen mesh 12 exposed in the printing pattern openings 14a; and the water repellent agent may unintentionally turn onto and adhere to a squeegeed surface side (the upper side in the drawing) through the printing pattern openings 14a. The structure 10 in an embodiment may be subjected to a surface treatment on the squeegeed surface side for better wettability. As a result, the water repellence is suppressed on the part onto which the water repellent agent for the water repellent layer 16 is adhered unintentionally, whereas the wettability is enhanced on the part onto which no water repellent agent is adhered This may facilitate filling of the ink into the printing pattern openings 14a and inhibit inclusion of voids in the ink, the voids being produced when the squeegeeing speed is high. Also, rolling of the ink may be facilitated during squeegeeing on the squeegeed surface, which in turn facilitates manifestation of thixotropy. Thus, the quality and efficiency of printing can be improved In other embodiments of the present invention, the surface treatment for improving wettability may be provided on the section of the printing pattern openings 14a and the screen mesh 12 exposed in the printing pattern openings 14a, thereby suppressing the reverse capillary action in the printing pattern openings 14a and structural water repellence as a structure.

The structure 10 in the embodiment may include a water repellent layer 16; but the present invention may also be applied to a structure not having a water repellent layer 16. Even if the water repellent layer 16 is not formed, problems such as degradation of printing quality may occur due to poor wettability of the squeegeed surface caused by structural water repellence, as described above; therefore, a surface modification process for improving wettability may be provided on the squeegeed surface to prevent degradation of printing quality.

In an embodiment of the present invention, the surface modification process for improving the wettability of the squeegeed surface may be achieved not by a surface treatment on the squeegeed surface only but by a surface modification treatment for improving the wettability of the sectional surface of the printing pattern openings and the printing substrate surface if necessary. The wettability of the printing substrate surface can thus be improved for the following reason: in many cases, the printing substrate surface and the sectional surface of the printing pattern opening may constitute a continuous "surface"; for example, the ink may flow along the sectional surface of the printing pattern openings having wettability thereof increased (improved) by one embodiment of the present invention, and the ink moves to a boarder edge adjacent to the printing substrate surface constituting one continuous surface and having low wettability; when the ink is less likely to move toward the printing substrate surface having poor wettability due to "wetting hysteresis" and "the pinning effect of wetting" and thus the amount of ink filling the printing pattern opening is short, the wettability of the printing substrate surface including the printing substrate surface side of the surroundings of the printing pattern openings may be improved

In the structure 10 according to an embodiment of the present invention, a surface modification treatment for improving wettability may be performed on a squeegeed surface of the screen mesh 12 before the emulsion layer 14 is formed; and moreover, a surface modification treatment for improving wettability may be performed on the printing substrate surface of the screen mesh 12 (a treatment for improving the tight adhesion of a coupling agent including an element M (M herein represents Ti, Al, or Zr) that is capable of -O-M bond by condensation reaction with functional groups of the substrate).

In an embodiment, a surface modification treatment for improving wettability can be performed by various methods. For example, a plasma dry process (e.g., a publicly known plasma sputtering method) may be used to form a film composed of SiOx, TiOx, etc. on a substrate such as the screen mesh 12. Alternatively, a plasma dry process (e.g., a publicly known plasma CVD method) can be used to form an amorphous carbon film on a substrate such as the screen mesh 12 and apply a plasma of an element such as oxygen or nitrogen having a large electron-withdrawing property to form a film on the surface layer of the amorphous carbon film. In another aspect, a modification gas including at least one element of an inert gas such as argon, oxygen, and nitrogen is made into plasma and applied directly onto a substrate such as the screen mesh 12. Thus, when the wettability is improved without forming an additional film on a substrate such as the screen mesh 12, the contamination of the printing medium or a production line due to removal of the ingredient of the additional film from the substrate, which is more likely to occur when the film is added, can be prevented; and additionally, the accuracy of the printing pattern openings can be inhibited from being varied depending on the thickness of the film.

The surface modification treatment for improving wettability according to an embodiment of the present invention can be performed on, e.g., all of a squeegeed surface, the sectional surfaces of the printing pattern openings, and the printing substrate surface, which constitute one continuous surface, thereby to facilitate filling of the ink; and further, the surface modification treatment can be performed on a desired part of the squeegeed surface, the sectional surfaces of the printing pattern openings, and the printing substrate surface (e.g., only the squeegeed surface and the sectional surfaces of the printing pattern openings). In order to perform the surface modification treatment for improving wettability on a desired part of the surfaces, publicly known masking may be previously provided on the part not subjected to the surface modification treatment.

When the surface modification treatment for improving wettability is performed by applying a plasma with high straightness, it is possible to apply the plasma to one surface or particular parts of the structure 10 (e.g., only the squeegeed surface side including the sectional surfaces of the printing pattern openings). Thus, the parts requiring water repellence or water and oil repellence (e.g., on the printing substrate surface side) can retain water repellence or water and oil repellence, and the surface modification treatment can be performed only on the parts requiring improvement of the wettability.

In an embodiment, the surface modification treatment for improving wettability particularly on the squeegeed surface can be performed by various methods within the purport of the present invention. Examples of such methods include a method wherein the diameter of the fiber threads of the screen mesh exposed in the printing pattern openings of the printing stencil is increased by wet plating or dry plating thereby to moderate the structural water repellence, a method wherein the surface roughness of the squeegeed surface side is increased by sandblasting, polishing, drug etching, etc., a method wherein the screen mesh is subjected to a surface treatment with an inorganic film composed of, e.g., SiOx or TiOx having higher wettability to water and oil than the screen mesh made of stainless steel, and a method wherein a surfactant is applied In an embodiment, the squeegeed surface subjected to a surface modification treatment for improving wettability should preferably have a contact angle with mineral spirit of less than 90° (at room temperature and a humidity of 25 to 35%) and should more preferably have a contact angle with pure water of less than 90° (at room temperature and a humidity of 25 to 35%). In another embodiment of the present invention, the squeegeed surface of the part including (the sectional surface of) the printing pattern openings subjected to a surface modification treatment for improving wettability should preferably have a contact angle with mineral spirit of less than 90° (at room temperature and a humidity of 25 to 35%) and should more preferably have a contact angle with pure water of less than 90° (at room temperature and a humidity of 25 to 35%). When the printing substrate surface side of the squeegeed surface subjected to a surface modification treatment for improving wettability exhibits water repellence, the contact angle with pure water on the squeegeed surface side (at room temperature and a humidity of 25 to 35%) should preferably be 99° or less and more preferably be less than 90°. Additionally, in still another embodiment of the present invention, when the printing substrate surface side of the squeegeed surface subjected to a surface modification treatment for improving wettability exhibits water repellence, the contact angle with pure water (at room temperature and a humidity of 25 to 35%) on the squeegeed surface side of the part including (the sectional surface of) the printing pattern openings subjected to the surface modification treatment for improving wettability should preferably be 99° or less and more preferably be less than 90°.

In yet another embodiment of the present invention, the planar printing substrate surface (having no openings therein) before the printing pattern openings are formed in the structure 10 may be previously subjected to water repellent treatment or oil repellent treatment, and then the printing pattern openings may be formed in the structure 10, so as to retain water repellence and oil repellence of the printing substrate surface of the structure 10 and retain excellent wettability with the ink on (the sectional surfaces of) the squeegeed surface and the printing pattern openings. Such a method may ensure prevention of the water repellent agent applied to the printing substrate surface side of the structure 10 from turning onto the printing pattern openings and the squeegeed surface side. For example, in a printing stencil (a metal mask) wherein printing pattern openings are formed by laser drilling for example, a water repellent agent, an oil repellent agent, etc. are previously applied onto a surface of a stainless steel plate corresponding to the printing substrate surface, and then the desired printing pattern openings are formed by applying a laser beam onto the stainless steel plate, so as to prevent degradation of wettability on the sectional surfaces of the printing pattern openings and the squeegeed surface due to the water repellent agent and the oil repellent agent.

In producing a printing stencil from a foil or plate, such as a metal foil or plate, a foil or plate made of an emulsion (including an emulsion applied onto a mesh) or other various resins, a foil or plate made of other plate-like or foil-like materials that can be used as materials of the printing stencil or made of a composite or laminate of these various materials (a part of the printing stencil), or a mesh, it is very effective, in order to achieve adequate wettability of the surfaces of the printing stencil without any impact on the other surfaces, to process and select (the substance of) the foil or plate, before the printing pattern openings are formed, such that the wettability of one surface constituting the printing substrate surface and the wettability of the opposite surface corresponding to the squeegeed surface are adapted for printing application, and then form through-holes in the foil or plate so as to correspond to the printing pattern openings in the printing stencil by laser processing, drilling, punching, photolithography, or other appropriate processing methods.

In other words, according to an embodiment of the present invention, there is provided a printing stencil structure wherein, as described above, appropriate surface wettability is previously selected and produced (by means including a surface treatment) on the plate or foil corresponding to the printing substrate surface and the squeegeed surface in accordance with the printing application for which the stencil is to be used, and then the printing pattern openings are formed to complete the structure. This structure may be modified such that at least one of the wettability of the printing substrate surface, the wettability of the sectional surfaces of the printing pattern openings (in the case of a screen stencil including a mesh, a mesh surface layer exposed to the printing pattern openings may be included), and the wettability of the squeegeed surface is different from the wettability of the other surfaces.

The above phrase "different from the wettability of the other surfaces" means that the contact angle with water (e.g., pure water) or oil (e.g., mineral spirit) is different in an environment having the same temperature and humidity, and includes the case where surface free energy is different, the case where surface roughness is different, and the case where both surface free energy and surface roughness are different. Non-limiting specific examples include: (1) the case where (the surface corresponding to) the printing substrate surface of a stainless steel plate included in a printing stencil is a water repellent surface having a contact angle with water of more than 90° (e.g. 100° or more), while the opposite surface corresponding to the squeegeed surface is a hydrophilic surface having a contact angle with water of less than 90° (e.g., a surface having a contact angle with water of ordinary stainless steel origin of about 70 to 80°), and then the printing pattern through-holes are formed in the stainless steel plate with the sectional surfaces of the through-holes having wettability of the stainless steel origin; (2) the case where the surface corresponding to the squeegeed surface of a stainless steel plate included in a printing stencil is a hydrophilic surface having a contact angle with water smaller than that of ordinary stainless steel origin of about 70 to 80° and thus having higher wettability, such that the structural water repellence caused by the unevenness produced when the fine printing pattern through-holes are formed later in the stainless steel plate has less tendency to inhibit filling of the water-based ink, and (3) the case where the printing substrate surface is water repellent as in the case (1), while the squeegeed surface is hydrophilic as in the case (2).

In the structure 10 according to an embodiment, when the screen mesh 12 includes a stainless steel part, a modification gas including an inert gas such as argon, oxygen, and nitrogen is made into plasma or radicals with a plasma apparatus that produces plasma in a vacuum (reduced pressure), atmospheric-pressure plasma apparatus, or a UV-light application apparatus, and is applied onto the printing substrate surface for improving wettability (activating the surface layer), and then a water/oil repellent layer having water repellence and/or oil repellence can be tightly formed via a coupling agent including an element M (M is herein Ti, Al, or Zr) capable of -O-M bond with functional groups in the stainless steel part by a condensation reaction, or a water/oil repellent layer composed of a coupling agent further containing fluorine can be tightly formed That is, it is known that, e.g., heating stainless steel at a high temperature (e.g., 500°C) in the atmosphere causes enrichment of Fe in the oxide film at the surface layer, oxidation of a hydrate in a passive film (formation of an oxide layer), and dehydration synthesis of the surface hydroxyl groups. As a result, an oxide film having low surface hydroxylation and composed mainly of Fe₂O₃ is formed on the stainless steel surface (Industrial Technology Center of Okayama Prefecture, "The Mode of the Removal of Protein from Stainless Steel Surface by Cleaning Operation," Satoshi Fukuzaki, Journal of High Temperature Society, Vol. 35, No. 3 (May 2009)). In this part, the secureness and tight adhesion of the coupling agent containing the element M capable of -O-M bond with the functional groups (hydroxyl groups) of the substrate by condensation reaction may be degraded In the structure 10 according to an embodiment of the present invention, a water/oil repellent layer can be formed securely by the above-described method In many cases, at least the parts of the printing stencil around the openings (apertures) that impact printing quality may be made of stainless steel having been subjected to heating at a temperature equal to or higher than the heat deformation temperature. Examples of such printing stencils include a printing stencil (metal mask) having printing pattern openings formed therein by application of laser beam or drilling and a screen mesh woven with fiber threads made of stainless steel molten and stretched

In an embodiment of the present invention, various remainders or stains may be left on the surface. Examples of such remainders and stains include remainders of emulsion in the printing pattern openings 14a (a part of the screen mesh 12 which is once coated with the emulsion and then exposed again) left when an emulsion layer 14 is formed by exposing and developing an emulsion (development involves removal of the emulsion from the screen mesh 12 by rinsing) in accordance with the printing pattern after application of the emulsion on the screen mesh 12, and the remainders of an etching drug on a metal stencil where a laser beam is used to drill a hole, and a chemical drug is used to etch the dross formed in the drilled hole. These remainders and stains may be irradiated with a plasma of a modification gas including an inert gas such as argon, oxygen, and nitrogen to reduce the remainders and stains on the surface and improve wettability (activate the surface layer), and then on this part having a modified surface, a water/oil repellent layer having water repellence and/or oil repellence can be tightly formed via a coupling agent including an element M capable of -O-M bond with functional groups in the substrate by a condensation reaction, or a water/oil repellent layer composed of a coupling agent further containing fluorine can be tightly formed One example of the coupling agent including an element M capable of -O-M bond with functional groups in the substrate is a titanate-based coupling agent that is commercially available as "Plenact 38S" (from Ajinomoto Fine-Techno Co., Inc.). As for aluminate-based coupling agents, the product named "Plenact AL-M" (alkyl acetate aluminum diisopropylate from Ajinomoto Fine-Techno Co., Inc.) is commercially available. Further, as for zirconia-based coupling agents, the product named "Ken-React NZ01" (from Kenrich Petrochemicals, Inc.) is commercially available.

Further, when the water/oil repellent layer composed of the fluorine-based coupling agent is formed on a part where the water/oil repellent layer is not necessary, the modification gas including an inert gas, oxygen, and nitrogen may be made into plasma or radicals and applied to suppress the water repellence or the oil repellence.

After the emulsion layer 14 is formed on the screen mesh 12, the structure yet to have the water repellent layer 16 may be subjected to the above-described surface treatment using plasma on the printing substrate surface side. Thus, an uneven surface in the form of wrinkles and/or dots may be formed on the emulsion layer 14, a water repellent agent such as a fluorine-containing silane coupling agent may be applied to the uneven surface to form a water repellent layer 16, and the water repellent layer formed in the recesses may be protected by the projections, such that the durability of the water repellent layer 16 is improved Further, when the uneven surface formed on the printing substrate surface side of the emulsion layer 14 is configured to have structural water repellence, the water repellence on the printing substrate surface side can be reinforced Still further, the printing substrate surface may be coated with an amorphous carbon film, an amorphous carbon film containing various elements, an inorganic film, etc. as a protection film.

For example, a screen mesh included in a printing stencil may be fixed together with another screen mesh using an adhesive or an adhesive tape when it is fixed on a printing frame using an adhesive or an adhesive tape (directly affixed stencil) or it is fixed on a combination stencil. Some parts of a screen mesh must be firmly adhered to a mating member for construction of the stencil; for example, the emulsion is fixedly adhered to the surface layer of the screen mesh. In an embodiment of the present invention, the surface layer of a constituent of the printing stencil or a screen mesh is subjected to a surface treatment (surface activation) by a plasma treatment, thereby reinforcing such joining.

The surface treatment using plasma according to one embodiment of the present invention may use a known modification gas as a raw material gas that can improve wettability of the surface of the substrate. Examples of such a modification gas include a modification gas (element) such as the air, oxygen, argon, neon, helium, xenon, nitrogen, or carbon dioxide that can open the chain of the molecular structure of a substrate to form an active site, and a modification gas (element) that can form various functional groups having polarities on the surface layer of the substrate. The plasma may be applied by using various methods, such as known plasma CVD methods, the method wherein an active gas is applied by corona discharge, the method wherein UV rays are applied, and an atmospheric pressure plasma method It is preferable to provide a plasma-based surface treatment by using an atmospheric pressure plasma method that is efficient and can be performed without decompressing the substrate in a vacuum apparatus. Further, the printing stencil may be composed of materials that tend to produce outgassing in a vacuum environment, such as an adhesive, an adhesive tape, an emulsion; therefore, in the plasma CVD method and plasma PVD method performed in a vacuum environment, these materials may be degraded to cause distortion or reduced durability of the stencil. In the method using corona discharge, uniform treatment on the substrate is difficult, as compared to the atmospheric pressure plasma. Additionally, in many cases, a printing pattern in a printing stencil may be formed with UV-sensitive emulsion, and there is possibility that the emulsion is degraded depending on the method of applying the UV rays. On the other hand, when the atmospheric pressure plasma method is used, such problems are solved, and additionally the operation is facilitated in an open normal pressure environment.

In the atmospheric plasma method according to an embodiment of the present invention, various modification gases as raw material gases may be made into plasma by the dielectric-barrier discharge method, the remote plasma method, etc., and the gas made into plasma may be sprayed onto the work or treated on other principles.

A surface treatment using plasma may be performed on the structure 10 according to an embodiment to modify a desired part of the surface of the structure 10. That is, since only the surface is modified and no film is formed on the surface, there is reduced risk of causing the problems of removal of the film itself and distortion of the structure 10 due to the internal stress of the formed film (this problem is significant when the film is formed on one side only). When a film is formed using plasma (e.g., when an inorganic film is formed as a protection film on the printing substrate surface (printing sheet side)), the film formed using plasma may be poorly adhesive and tend to be readily removed in the case where the screen mesh 12 or a tabular member having a plurality of holes is rinsed insufficiently, formed of a stainless steel that tends to form a passive layer, or coated with a Ni plating, etc. that also tends to form a passive layer. By contrast, in the structure 10 according to an embodiment, there are no such problems originated from the adhesion, because plasma is used to modify the surface portion.

Further, in the case where, e.g., when a treatment for water repellence or water and oil repellence is intentionally applied to a printing substrate surface of the printing stencil or a screen mesh, the water repellent or water and oil repellent surface treatment material (particularly liquid material having a low surface tension) may unintentionally enter the printing pattern openings of the printing stencil and spread therethrough onto the squeegeed surface, resulting in surface treatment for water repellence or water and oil repellence on the squeegeed surface, it may be possible either to wipe the squeegeed surface using a diluted solvent or water repellent agent or to physically grind or remove the surface layer on the squeegeed surface side.

The structure 10 in an embodiment may be used for a printing method called "solid printing," wherein no pattern part is formed of emulsion, etc. on a screen mesh, only the screen mesh is strung on a frame body, and an ink is transferred through apertures (openings) in the screen mesh onto the printing substrate to form a continuous plane. Further, the structure 10 can also be applied to printing stencils which are not used with frame bodies. For example, a metal foil (printing stencil) made by applying a laser beam onto a thin stainless steel plate to form printing pattern openings can be directly retained (chucked) in a dedicated retainer of a printing machine, etc. and provided for printing without being attached on a frame body.

With the structure 10 according to the embodiment described above, degradation of printing quality and efficiency (e.g., blur printing and insufficient rinsing) due to unintentional water/oil repellence can be suppressed by providing a surface treatment for improving wettability on the squeegeed surface of the structure 10. Additionally, when the screen mesh 12 includes a stainless steel part, a modification gas including an inert gas, oxygen, and nitrogen is made into plasma and is applied onto the printing substrate surface for improving wettability, and then a water/oil repellent layer having water repellence and/or oil repellence can be tightly formed via a coupling agent including an element M (M is herein Ti, Al, or Zr) capable of -O-M bond with functional groups in the stainless steel part by a condensation reaction, or a water/oil repellent layer composed of a coupling agent further containing fluorine can be tightly formed

In an embodiment, the squeegeed surface of the structure 10 is subjected to a surface modification treatment for improving wettability; but it is not essential to provide a surface modification treatment for improving wettability on the squeegeed surface. As described above, a surface modification treatment for improving wettability can improve jointing of constituents such as a printing stencil and enable tight adhesion of the water/oil repellent layer on the stainless steel parts. In an embodiment, an emulsion layer 14 is formed on the screen mesh 12; but other members such as a porous sheet or a metal mask having a plurality of through-holes can be included in the structure in an embodiment.

### EXAMPLES

The structure in an embodiment was examined for the surface modification state by the following method

### 1. Observation of Surface Shape and Wettability

An emulsion stencil for printing like a capacitor electrode was prepared as follows. A publicly known diazo-based photosensitive emulsion is applied onto a stainless steel mesh #500-19-28 serving as a substrate and supported on a printing frame of a size 450 mm by 450 mm in a combination composed of a resin mesh; and then a printing pattern is formed in a printing pattern area (150 mm by 150 mm) by a publicly known photolithographic method, wherein a pattern sequence including a number of rectangular pattern openings each having a size of 300 µm by 100 µm arranged in a column at intervals of 50 µm and a pattern sequence including a number of rectangular pattern openings each having a size of 250 µm by 100 µm arranged in a column at intervals of 100 µm are arranged alternately in a column at intervals of 100 µm. The prepared sample irradiated at the squeegeed surface thereof (the pattern openings, the exposed meshes, and an emulsion part) with a plasma of Ar gas as a raw material at an atmospheric pressure was taken as Example 1; the prepared sample irradiated with a plasma of the atmosphere (the air composed of nitrogen and oxygen) at an atmospheric pressure was taken as Example 2; and the prepared sample not subjected to such surface treatment with a plasma was taken as Comparative Example 1. Further, unwoven cloth impregnated with a fluorine-containing silane coupling agent ("FG-5010Z130-0.2" from Fluoro Technology Corporation) was applied to only the printing substrate surface side of the prepared sample (emulsion stencil). Then, the sample irradiated at the squeegeed surface thereof with a plasma of Ar gas as a raw material at an atmospheric pressure was taken as Example 3; the sample irradiated at the squeegeed surface thereof with a plasma of the atmosphere (the air composed of nitrogen and oxygen) at an atmospheric pressure was taken as Example 4; and the sample not subjected to such surface treatment with a plasma (the sample only coated with a fluorine-containing silane coupling agent on the printing substrate surface side) was taken as Comparative Example 2. Still further, four stainless steel meshes #500-19-28 described above were strung on printing frames each having a size of 450 mm by 450 mm (with no emulsion applied thereto). Of these four samples, one which was not subjected to surface treatment was taken as Comparative Example 3; one in which a fluorine-containing silane coupling agent was applied to the printing substrate surface side only was taken as Comparative Example 4; one in which, as in Comparative Example 4, a fluorine-containing silane coupling agent is applied to the mesh, and then a plasma of Ar gas as a raw material was applied to the squeegeed surface side at an atmospheric pressure was taken as Example 5; and one in which, as in Comparative Example 4, a fluorine-containing silane coupling agent was applied to the mesh, and then a plasma of the atmosphere (the air composed of nitrogen and oxygen) was applied to the squeegeed surface side at an atmospheric pressure was taken as Example 6.

Since a screen mesh made of stainless steel is a substrate which is formed of intersecting threads and has complex unevenness, and a droplet falling on one side of the screen mesh moves through the openings of the mesh to the other side, it is difficult to grasp the strict surface condition (contact angle) of the one side only (e.g., only a part directly irradiated with a plasma having a high straightness for surface modification). To overcome this problem, three rectangular planar plates were prepared (size: 100 mm by 100 mm, thickness: 1 mm, surface roughness (Ra): about 0.075 µm), which were made of a stainless steel (SUS304-2B) and had no through-holes extending to the other side. These plates were coated with a fluorine-containing silane coupling agent. Then, the plate not irradiated with an atmospheric pressure plasma was taken as Reference Example 1; the plate irradiated with a plasma of Ar gas as a raw material at an atmospheric pressure at a surface coated with the fluorine-containing silane coupling agent was taken as Reference Example 2; and the plate irradiated with a plasma of the atmosphere (the air composed of nitrogen and oxygen) was taken as Reference Example 3. In the plasma treatment performed on the samples, a plasma head continuously generating and applying an atmospheric pressure plasma was reciprocated over the irradiation surfaces of the samples, while the irradiation surfaces of the samples were moved at a constant pitch under the reciprocating plasma head, such that a certain ranges of the surfaces are irradiated with the atmospheric pressure plasma. The details are as follows. The method of applying an atmospheric plasma in other Examples is the same unless otherwise specified

### <Plasma Treatment with Ar gas>

The apparatus HPW-01 from Well Corporation
Plasma application range from the plasma head: φ5mm
Process conditions:
Plasma power supply (RF power supply) output 200W
Argon gas flow rate: 61/min
Feed (pass) rate of the plasma head (on the work processing surface): 220 mm/sec
Distance between the plasma head and the work surface: 8 mm
Number of times of applications of plasma at application sites: one operation included a total of two times of application of plasma onto the object surface during one reciprocation over the object surface. (One reciprocation includes two ways.)

With such a plasma application method and application process, each time one operation is completed for one surface of the object sample that requires treatment, the samples were shifted by 4 mm, such that all the surfaces of the sample that require modification are treated

### <Plasma Treatment with the Atmosphere>

The apparatus WAP003 from Well Corporation
Plasma application range from the plasma head: φ10mm
Process conditions:
Plasma power supply output 282-285W
Carrier gas: clean compressed air supplied from a compressor
Flow rate: 19.4-19.61/min
Feed (pass) rate of the plasma head (on the work processing surface): 220 mm/sec
Distance between the plasma head and the work surface: 8 mm
With these conditions, the plasma head was reciprocated over the object surface, and one operation included a total of four times of application of plasma onto the object surface (two reciprocations of the plasma head).

With such a plasma application method and application process, each time one operation is completed for one surface of the object sample that requires treatment, the samples were shifted by half of the plasma application range of the plasma head φ10 mm (i.e., 5 mm), such that all the surfaces of the sample that require modification are treated

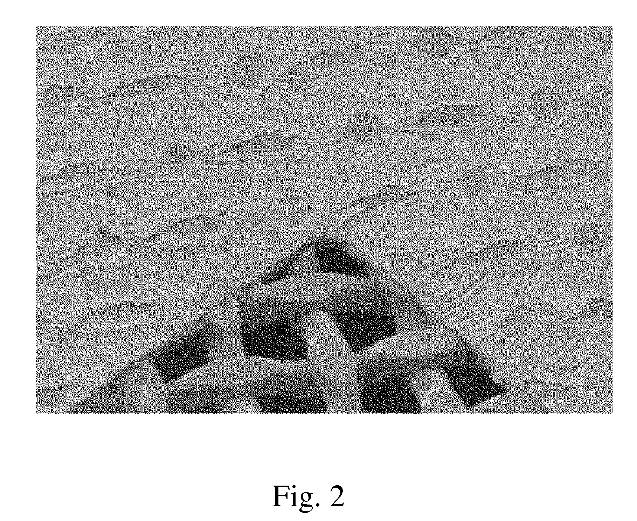

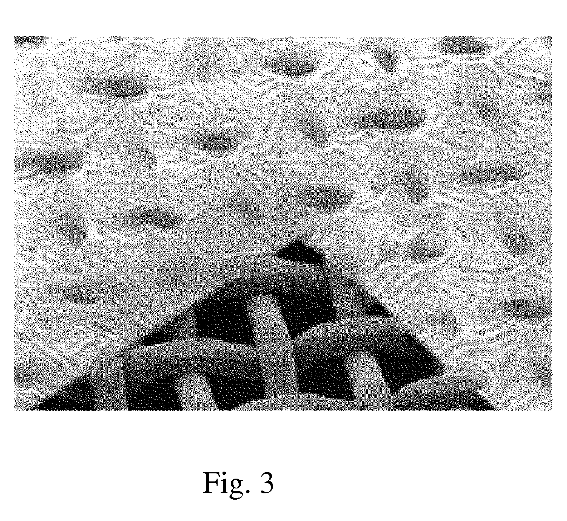

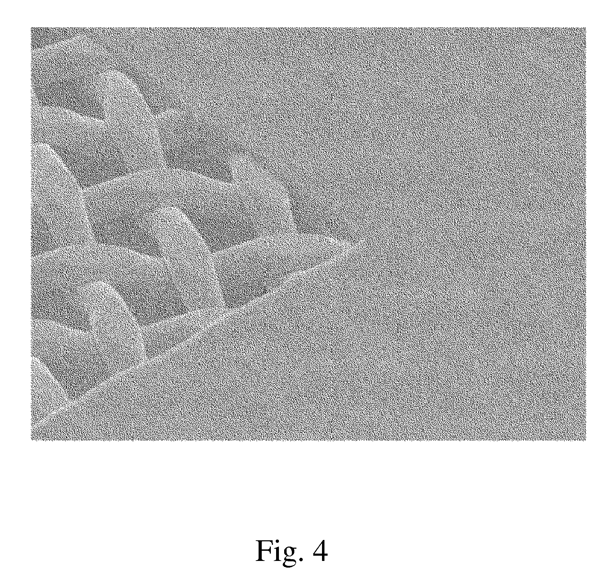

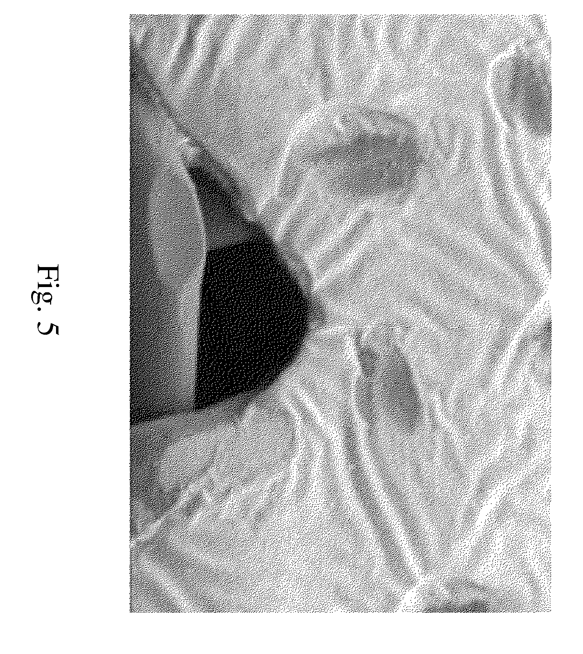

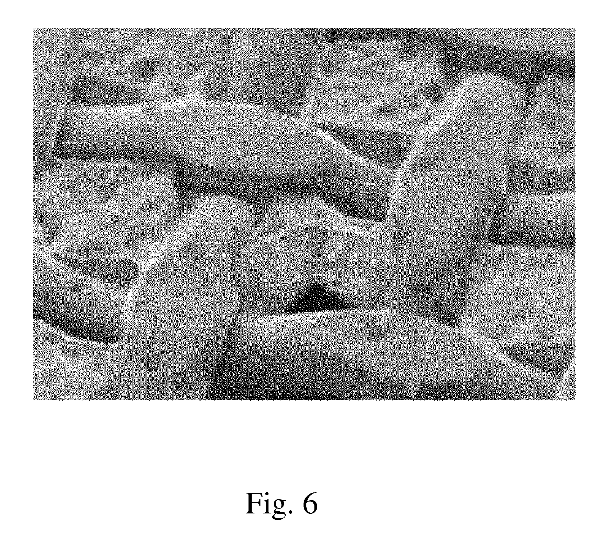

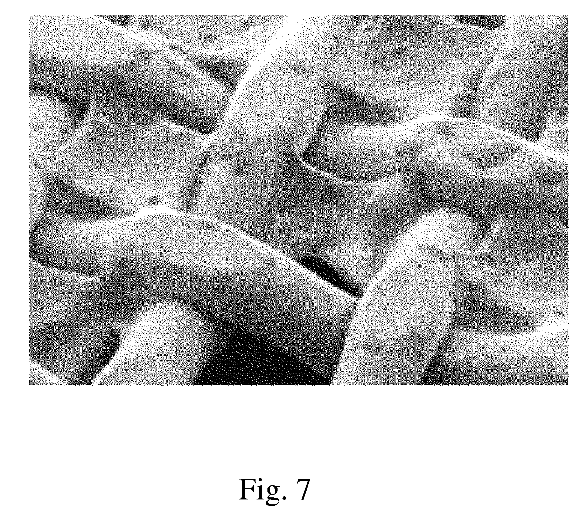

Figs. 2, 3, and 4 shows electron microscope photographs of printing substrate surfaces of Example 1, Example 2, and Comparative Example 1 (400 magnifications); and Fig. 5 shows an electron microscope photograph of a printing substrate surface of Example 2 (1,000 magnifications). Fig. 6 shows an electron microscope photograph of a squeegeed surface of Example 2 (1,000 magnifications); and Fig. 7 shows an electron microscope photograph of a squeegeed surface of Comparative Example 1 (1,000 magnifications). Each of Examples shows an uneven surface in the form of wrinkles and dots formed in the surface layer of the emulsion which is absent in Comparative Example.

Thus, it was confirmed that application of an atmospheric pressure plasma onto the squeegeed surface of an emulsion stencil increases surface roughness of not only the squeegeed surface but also the printing substrate surface on the opposite side. This may suggest that, when an atmospheric pressure plasma was applied onto the squeegeed surface of the emulsion stencil, not only the chemical activity of the plasma-irradiated surfaces was improved, but also the surface wettability of the squeegeed surface can be further improved due to increase of surface roughness, and also suggest that, since the surface roughness of the printing substrate surface of the emulsion stencil which is an opposite surface can be simultaneously increased, the above-described water repellence (the structural water repellence surface and the structural oil repellence surface can be formed because of the uneven structure) may also be improved when achieving water repellence of the printing substrate surface side of the emulsion stencil of which the squeegeed surface side is irradiated with an atmospheric pressure plasma.

The change in hydrophilicity (oleophilicity) before and after plasma application was measured by measuring the average values of contact angles with water (pure water) and mineral spirit (oil) which is a petroleum-based solvent at any ten points on (the treated surfaces of) Reference Examples 1 to 3, and the squeegeed surfaces and the printing substrate surfaces of Comparative Examples 2 to 4 and Examples 3 to 6. The measurement results are shown below.
All the contact angles described herein were measured under the following conditions.

Measurement apparatus: portable contact angle gauge PCA-1 from Kyowa Interface Science Co., Ltd
Measurement range: 0 to 180° (display resolution 0.1°)
Measurement method: contact angles were measured five seconds after dripping of a measurement liquid (drop method).

Measurement liquid: pure water and mineral spirit
Amount of dripped liquid: 1.5 µl for each measurement (for both pure water and the mineral spirit)
Measurement environment normal pressure, room temperature 25°C ± 3°C, humidity 30% ± 5%
In the measurement results of contact angles below, the term "water" indicates (contact angles with) pure water, and the term "oil" indicates (contact angles with) the mineral spirit. Water (pure water) and oil (the mineral spirit) were used because inks used for printing include water-based and oil-based inks, and the mineral spirit (a petroleum-based solvent) may be used as a diluent for oil-based inks.

In Comparative Examples and Examples corresponding to Comparative Examples, the measurement time of the contact angles was adjusted such that contact angles were measured when almost the same amount of time has elapsed after application of the atmospheric plasma onto the samples.

First, the measurement result of the contact angle of Comparative Example 3 (the screen mesh #500-19-28 made of stainless steel not subjected to a treatment) measured from the squeegeed surface side is as follows.
water:106.3° oil: 31.9°

It should be noted that the measurement was performed only on one surface because this sample was not subjected to a treatment; and thus the measurement was not performed on the printing substrate surface side. The measurement results of the contact angle with water suggest the following. When the water-based ink was used on mesh openings of the stainless steel screen mesh #500-19-28, the reverse capillary action (pressure) had already occurred and inhibited filling of the ink. As a result, the air remained in the mesh openings, the water-based ink was inhibited from being filled in the mesh openings and from being transferred to the printing substrate side during squeegeeing. Additionally, the remaining air made voids that tend to be caught in the ink and transferred to the printing sheet by squeegeeing.

### <Stainless Steel Plates (Reference Examples)>

Next, the measurement results of the contact angles of the stainless steel plate (Reference Example) are as follows.
- Reference Example 1 (not irradiated with plasma)
   water:114.3° oil: 53.8° Water and oil repellence can be observed
- Reference Example 2 (irradiated with Ar gas plasma)
   water: 65.9° oil: 21.3°
- Reference Example 3 (irradiated with atmospheric plasma)
   water: 62.7° (water only)

It was observed that the contact angles with water and oil of the surface layers of the stainless steel plates were significantly reduced when plasma of Ar gas or the atmosphere was applied

This suggests that even a part where a film having a high water and oil repellence such as shown in the measurement results of the contact angle of the fluorine-containing silane coupling agent in Reference Example 1 is formed can be subsequently irradiated with atmospheric pressure plasma such that the plasma destroys or modify the structure of the film exhibiting the water and oil repellence, thereby significantly suppressing the water and oil repellence.

### <Samples Having Emulsion Patterns>

Next, the measurement results for the samples having emulsion patterns of the printing stencil are shown below. The droplets of pure water (water) and the mineral spirit (oil) used for the measurement of the contact angles straddled an opening in the emulsion pattern or the screen mesh made of stainless steel exposed to the opening. When a planar part of the emulsion having no opening pattern is subjected to the same water and oil repellence treatment as in this test for measurement of the contact angles, the contact angles are 110° for water and 50° for oil.
- The printing substrate surface of Comparative Example 2 (prior to Ar gas plasma application)
   water:128.7° oil: 85.5°
- The squeegeed surface of Comparative Example 2 (prior to Ar gas plasma application)
   water:129.6° oil: 89.5°

At two points among the ten measurement points for oil, the measured contact angles exceeded 90° to be 93.1° and 92.3°. It can be understood that the contact angles with water and with oil are both very large as compared to the planar part of the emulsion having no opening pattern and subjected to water and oil repellence treatment. On the squeegeed surface not coated with the fluorine-containing silane coupling agent, contact angles almost as large as those on the printing substrate surface side were measured for both water and oil, indicating that the fluorine-containing silane coupling agent turned onto the squeegeed surface from the printing substrate surface coated with the silane coupling agent. This measurement result strongly suggests that, at the parts wherein the contact angle with water and oil exceeded 90° (the emulsion pattern openings or the openings in the screen mesh exposed to the emulsion pattern openings), water (the water-based ink) and oil (the oil-based ink or an ink including a solvent binder and a diluent) received a reverse capillary pressure and were inhibited from entering and permeating the opening part.

Next, the measurement results for the samples subjected to surface modification with atmospheric pressure plasma are as follows.
- The printing substrate surface of Example 3 (after Ar gas plasma application)
   water:85.1° oil: 66.4°
- The squeegeed surface of Example 3 (after Ar gas plasma application)
   water:98.7° oil: 77.1°
- The printing substrate surface of Example 4 (after atmospheric plasma application)
   water:80.6° oil: 69.3°
- The squeegeed surface of Example 4 (after atmospheric plasma application)
   water:82.8° oil: 74.9°

Thus, when the Ar gas plasma or the atmospheric plasma is applied onto the squeegeed surface, the contact angles with water and oil can be significantly reduced, and water and oil are more likely to enter the emulsion pattern openings; as for oil, the contact angle was less than 90°, indicating that the reverse capillary action on water (water-based ink) and oil (oil-based ink) was significantly suppressed Further, the atmospheric plasma, containing electron-attractive oxygen and nitrogen atoms, can reduce the contact angle with water as compared to Ar gas plasma.

### <Samples Having Stainless Steel Screen Mesh Only>

Next, the measurement results for the samples having only stainless steel screen mesh and subjected to surface modification with atmospheric pressure plasma are as follows.
- The printing substrate surface of Comparative Example 4 (prior to Ar gas plasma and atmospheric plasma application)
   water:132.6° oil: 97.5°
- The squeegeed surface of Comparative Example 4 (prior to Ar gas plasma and atmospheric plasma application)
   water:131.8° oil: 94.9°

Both the contact angles with water and oil were very large as compared to those for the stainless steel screen mesh #500-19-28 not subjected to a treatment (water: 106.3°, oil: 31.9°). The contact angles were large due to increase in the structural water repellence and the structural oil repellence produced by the water and oil repellence treatment on the mesh. Since the openings in the screen mesh were small, the contact angles with oil exceeded 90°. This indicates that the reverse capillary pressure for water (water-based ink) and oil (oil-based ink) is very large. Next, the measurement results for the samples subjected to surface modification with atmospheric pressure plasma are as follows.
- The printing substrate surface of Example 5 (after Ar gas plasma application)
   water:88.6° oil: 81.6°
- The squeegeed surface of Example 5 (after Ar gas plasma application)

   water:88.8° oil: 60.3°
- The printing substrate surface of Example 6 (after atmospheric plasma application)
   water:79.6° oil: 83.1°
- The squeegeed surface of Example 6 (after atmospheric plasma application)
   water:70.8° oil: 85.9°

Thus, plasma application suppressed the water and oil repellence of the fluorine-containing silane coupling agent and produced contact angles with water and oil less than 90°. For the planar plate made of stainless steel, the contact angles on the surfaces irradiated with various atmospheric pressure plasmas were significantly smaller than 90°; but for <Samples Having Emulsion Patterns> and <Samples Having Stainless Steel Screen Mesh Only>, the apparent reduction in contact angle was small, because only the squeegeed surface side was treated with atmospheric pressure plasma, and thus water (pure water) drops or oil (mineral spirit) drops for measuring the contact angles dripped onto the squeegeed surface side or the printing substrate surface side reached the opposite surface through the openings in the screen mesh thereby to contact both the squeegeed surface and the printing substrate surface having different wettabilities. As a result, the contact angle with water or oil on the squeegeed surface side treated with atmospheric pressure plasma was larger than the actual contact angle on this part only (the contact angle only on the surface part modified by applying a fluorine-containing silane coupling agent and then directly irradiated with plasma, as in the case of a planar plate); and the contact angle on the printing substrate surface side was smaller than the actual contact angle on this part only (the contact angle only on the surface part of a planar plate where a fluorine-containing silane coupling agent was applied but plasma was not applied). This suggests that the actual printing partially achieves, e.g., facilitated separation of the final ink-contacting part from the printing screen stencil (water and oil repellence of the stencil) in the strict printing substrate surface part of the stencil (the surface part where a fluorine-containing silane coupling agent was applied but plasma was not applied) and affinity for the ink for blending and rolling of the ink (hydrophilicity and oleophilicity of the stencil) in the strict squeegeed surface part (the surface part modified by applying a fluorine-containing silane coupling agent and then directly irradiated with plasma).

### 3. Observation of Effectiveness of Modification of Only One Side of Screen Mesh by Atmospheric Pressure Plasma Treatment

In a printing stencil and a printing screen mesh, the printing substrate surface side and the squeegeed surface side are connected via a through-hole, and the printing substrate surface side is required to have water (oil) repellence for preventing the ink from blurring and improving clearness of the ink, whereas the squeegeed surface side may be required to have affinity for the ink for facilitating filling of the ink and improving thixotropy of the ink. The surface modification was performed on one surface of the printing stencil and the printing screen mesh by atmospheric pressure plasma treatment, and the impact on the other surface was observed

A mesh #500-19-28 made of stainless steel (SUS304) and having a size of 100 mm by 100 mm was prepared An amorphous carbon film containing Si was formed on one surface (surface X) of the sample to a thickness of about 100 nm by a known plasma CVD method using trimethylsilane gas as a raw material gas, and then the sample was irradiated with oxygen plasma and taken out of the plasma CVD apparatus; and the fluorine-containing silane coupling agent ("FG-5010Z130-0.2" from Fluoro Technology Corporation) was applied onto the surface X. Next, this mesh substrate was suspended in the air without blocking the surface X side and was subjected to an atmospheric pressure plasma treatment (wherein the modification gas was the air, and the plasma can pass through the mesh substrate from the surface Y to the surface X). The detection was made, both before and after the treatment, on elements from the surface layer of the mesh substrate, and the results were compared The raw material gas was dry air supplied from a compressor and made into plasma.

The amounts of oxygen atoms were measured by FE-SEM on the surface X and the surface Y which is irradiated with plasma, and the amounts of oxygen atoms before and after the atmospheric pressure plasma irradiation were compared The purpose of measuring the amounts of oxygen atoms was to measure the amount of oxygen remaining on the substrate after being made into plasma in the air and applied onto the substrate. It was previously confirmed that when no atmospheric plasma was applied, almost no oxygen was detected from the surface Y of the mesh substrate. The FE-SEM used was SU-70 from Hitachi High-Technologies Corporation, and measurements were performed with conditions of mapping x 10,000, acceleration voltage 7 kV, and probe current "medium."

The amount of oxygen detected on the surface X was 7.11 mass% before application of the plasma and was 7.66 mass% after application of the plasma; the amount of oxygen detected were almost the same. On the other hand, about 2 mass% of oxygen was detected on the surface Y (the plasma application surface). Thus, the surface Y was subjected to an atmospheric pressure plasma treatment without any significant impact of application of the atmospheric pressure plasma on the surface X.

### 4. Observation of Printing Quality due to Improved Wettability of Squeegeed Surface

A mesh (#500-19-28) made of stainless steel (SUS304) was prepared; and an emulsion screen stencil (printing stencil) having a size of 450 mm by 450 mm (450 squared frame) was prepared wherein the size of the mesh part in a combination was 200 mm by 200 mm, and the size of the printing pattern effective area was 150 mm by 150 mm. The thickness of the emulsion was about 2 µm. In the entire surface of the printing pattern effective area of the screen stencil, a pattern having openings with a size of 600 µm by 300 µm was formed, leaving the vertical and horizontal space of 200 µm.

An amorphous carbon film was formed by a known plasma CVD method to a thickness of about 100 nm on the printing substrate surface of the screen stencil on which the pattern is formed; subsequently, a primer layer of a fluorine-containing silane coupling agent was formed, which was composed of a film formed by applying a nitrogen gas made into plasma onto the amorphous carbon film; and then, a fluorine-containing silane coupling agent ("FG-5010Z130-0.2" from Fluoro Technology Corporation) was applied onto both the printing substrate surface and the squeegeed surface and dried The purpose of applying the fluorine-containing silane coupling agent onto both surfaces was to ensure that the fluorine-containing silane coupling agent is applied onto the squeegeed surface (reproduce the state where the fluorine-containing silane coupling agent turns onto the squeegeed surface). This sample was taken as Comparative Example 5. Further, the air (the atmosphere) was made into plasma by a known atmospheric plasma method and applied onto the squeegeed surface side of the screen stencil formed in the same manner. This sample was taken as Example 7. Likewise, a sample irradiated with argon gas plasma was taken as Example 8. The averages of the contact angles with water (pure water) measured at arbitrary ten points on the squeegeed surfaces of Examples 7 and 8 were 88° and 84°, respectively. The atmospheric pressure plasma was applied with the following conditions.

### - Example 7

The apparatus WAP003 from Well Corporation
Plasma application range from the plasma head: φ10mm
Process conditions:
Plasma power supply output 282-285W
Carrier gas: clean compressed air supplied from a compressor
Flow rate: 19.4-19.61/min
Feed (pass) rate of the plasma head (on the work processing surface): 220 mm/sec
Distance between the plasma head and the work surface: 8 mm

With these conditions, the plasma head was reciprocated over the object surface, and one operation included a total of four times of application of plasma onto the object surface (two reciprocations of the plasma head).

With such a plasma application method and application process, each time one operation is completed for one surface of the object sample that requires treatment (the region on the squeegeed surface side including a pattern area having a size in combination of about 200 mm by 200 mm), the samples were shifted by half of the plasma application range of the plasma head φ10 mm (i.e., 5 mm), such that all the surfaces of the sample that require modification are treated

### - Example 8

Apparatus: HPW-01
Head plasma application range: φ5mm
Process conditions:
Plasma power supply (RF power supply) output 200W
Argon gas flow rate: 61/min
Feed (pass) rate of the plasma head (on the work processing surface): 220 mm/sec
Distance between the plasma head and the work surface: 8 mm
Number of times of applications of plasma at application sites: one operation included a total of two times of application of plasma onto the object surface during one reciprocation over the object surface. (One reciprocation includes two ways.)

With such a plasma application method and application process, each time one operation is completed for one surface of the object sample that requires treatment (the region on the squeegeed surface side including a pattern area having a size in combination of about 200 mm by 200 mm), the samples were shifted by 4 mm, such that all the surfaces of the sample that require modification are treated

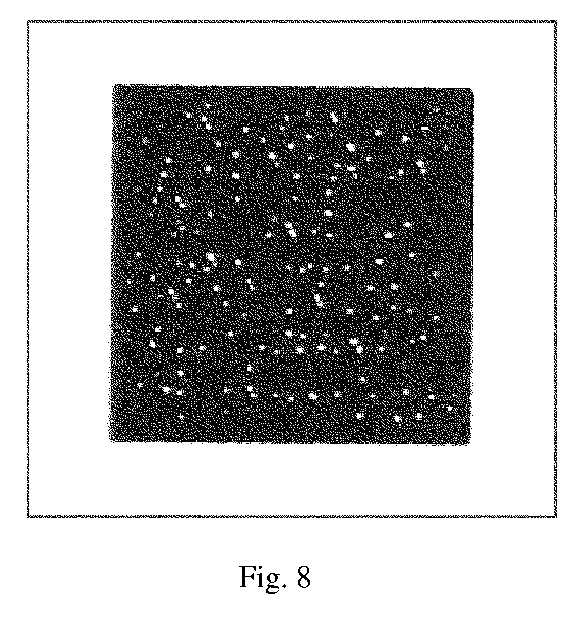

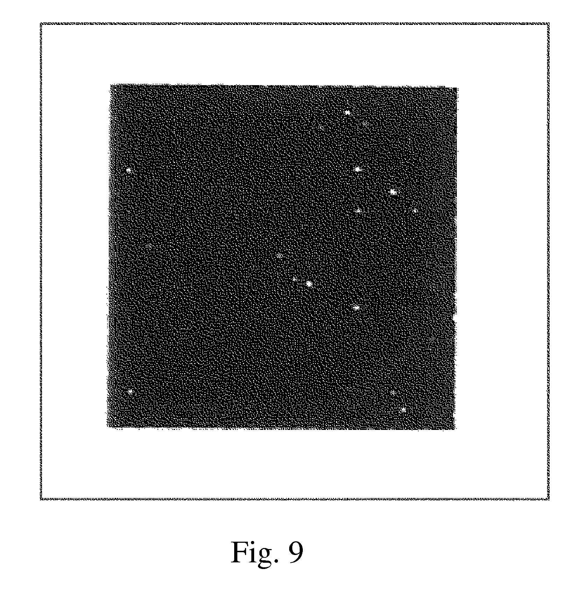

The screen stencils of Comparative Example 5 and Examples 7 and 8 were used for printing by a known screen printing method. The printing squeegee was made of urethane, the squeegee speed was 500 mm/sec, and the printing substrate was a known ceramic green sheet for capacitors. The printing conditions were the same for all the samples. Fig. 8 shows a photograph of a print printed with a screen stencil of Comparative Example 5; and Fig. 9 shows a photograph of a print printed with a screen stencil of Example 7 (the print printed with Example 8 was the same as that printed with Example 7). The photographs of the prints, taken in the same field of vision (with the same magnification) for comparison, reveal that Examples 7 and 8 significantly reduced pinholes (white dots) as compared to Comparative Example 5. Thus, increased wettability on the squeegeed surface side of the printing stencil (increased surface free energy and surface roughness) efficiently suppresses blur printing, and occurrence of pinholes caused by voids (air) caught in the ink due to wettability (reverse capillary action on the ink due to water and oil repellence) on the squeegeed surface of the printing stencil. There was no recognized degradation of printing quality such as blurring caused by change in wettability (e.g., degradation of water and oil repellence) on the printing substrate surface side due to modification (increase) of wettability on the squeegeed surface side.

## Claims

1. A structure for screen printing having a plurality of through-holes,
wherein at least a part of the structure is subjected to surface modification treatment for better wettability.

2. The structure of claim 1 wherein the surface modification treatment is provided to at least a part of a squeegeed surface.

3. The structure of claim 2 wherein a contact angle with mineral spirit on the part of the squeegeed surface subjected to the surface modification treatment is smaller than 90° (at room temperature and a humidity of 25 to 35%).

4. The structure of claim 2 wherein a contact angle with pure water on the part of the squeegeed surface subjected to the surface modification treatment is smaller than 90° (at room temperature and a humidity of 25 to 35%).

5. The structure of claim 2, wherein
a printing substrate surface has water repellence, and
a contact angle with pure water on the part of the squeegeed surface subjected to the surface modification treatment is 99° or smaller (at room temperature and a humidity of 25 to 35%).

6. The structure of claim 5 wherein a contact angle with pure water on the part of the squeegeed surface subjected to the surface modification treatment is smaller than 90° (at room temperature and a humidity of 25 to 35%).

7. The structure of claim 5 wherein the printing substrate surface includes fluorine atoms.

8. The structure of claim 1 wherein in the surface modification treatment, a film is formed by a plasma dry process, or a modification gas is made into plasma and applied by a plasma dry process.

9. The structure of claim 8 wherein the plasma dry process is an atmospheric pressure plasma method

10. The structure of claim 8 wherein the modification gas includes at least one of an inert gas, nitrogen, and oxygen.

11. The structure of claim 1, comprising:
a substrate including a stainless steel part formed through heating at a temperature equal to or higher than a heat distortion temperature, at least a part of a printing substrate surface being subjected to the surface modification treatment; and
a water/oil repellent layer having water repellence and/or oil repellence placed on the part of the printing substrate surface of the substrate subjected to the surface modification treatment via a coupling agent containing an element M (M is selected from a group consisting of Ti, Al, and Zr) capable of -O-M bond with functional groups in the substrate by a condensation reaction, or a water/oil repellent layer composed of the coupling agent further containing fluorine.

12. The structure of claim 1 wherein the structure is any one of a screen mesh, a porous sheet, and a metal mask.

13. A printing stencil comprising the structure of claim 1, wherein
the structure is composed of a screen mesh having a plurality of through-holes and an emulsion layer formed on the screen mesh and having printing pattern openings, and
at least a part of the screen mesh on which the emulsion layer is formed is subjected to surface modification treatment for better wettability.

14. The printing stencil of claim 13, wherein
in the surface modification treatment, a modification gas is made into plasma and applied by an atmospheric pressure plasma method, and
at least a part of the emulsion layer subjected to the surface modification treatment has an uneven surface in a form of wrinkles and/or dots.

15. A method of manufacturing a structure for screen printing, comprising the steps of:
(a) preparing a substrate having a plurality of through-holes; and
(b) providing surface modification treatment for better wettability on at least a part of the substrate.

16. A method of manufacturing a printing stencil for screen printing, comprising the steps of:
(a) preparing a screen mesh having a plurality of through-holes;
(b) forming an emulsion layer having a plurality of printing pattern openings on the screen mesh; and
(c) providing surface modification treatment for better wettability to at least a part of the screen mesh on which the emulsion layer is formed
